# EUROPEAN PATENT APPLICATION

(11) **EP 4 760 773 A1**
(43) Date of publication of application: **17.06.2026**
(21) Application number: 24852052.0
(22) Date of filing: 27.06.2024
(51) Int. Cl.: H01J 37/32, H03H 7/01, H03H 7/38

(54) **POWER TRANSFER DEVICE FOR COUPLING RF POWER AND DC PULSE VOLTAGE AND TRANSFERRING SAME TO LOAD**

(30) Priority: 07.08.2023 KR 20230103142
(71) Applicant: MKS KOREA LTD., Giheung-gu Yongin-si, Gyeonggi-do 17086 (KR)
(72) Inventor: JU, Hyun Mo, Daejeon 34022 (KR); JANG, Jeong Seok, Sejong 30064 (KR); JUNG, Jae Chul, Sejong 30115 (KR)
(74) Representative: MKS IP Association
(86) International application number: PCT/KR2024/008950
(87) International publication number: WO 2025/033696

(57) **Abstract**

A power delivery apparatus according to an embodiment of the present invention comprises: an impedance matching network (IMN) for delivering RF power from an RF generator to a load; a band-stop filter (BSF) for delivering DC pulse voltage from a pulsed DC generator to the load and suppressing the RF power from being transferred to the pulsed DC generator; a DC blocking capacitor connected to an output terminal of the IMN and suppressing the DC pulse voltage through an output terminal of the BSF from being transferred to the IMN; and an impedance converter connected to an output terminal of the BSF and changing impedance of the RF power incident on the BSF. An output terminal of the impedance converter and an output terminal of the DC blocking capacitor are connected to each other and then connected to the load through a transmission line.

## Description

### [Technical Field]

The present invention relates to a semiconductor device manufacturing apparatus, and more particularly, to an apparatus for delivering RF power and DC pulse voltage to form plasma in a plasma process chamber used in semiconductor manufacturing.

### [Background Art]

A plasma etching apparatus uses a combination of high-frequency RF source power for plasma generation and low-frequency RF bias power for controlling ion energy incident on a substrate. Typically, the RF source power uses a frequency of 3 MHz or higher to form high plasma density. Conversely, the bias frequency of the RF bias power uses a relatively low frequency of less than 3 MHz.

In plasma etching processes according to miniaturization technology of semiconductor devices, problems regarding etching uniformity, etching selectivity, and anisotropic etching characteristics continue to occur. To solve the aforementioned problems, RF pulse waves that periodically modulate RF power instead of continuous waves are being used.

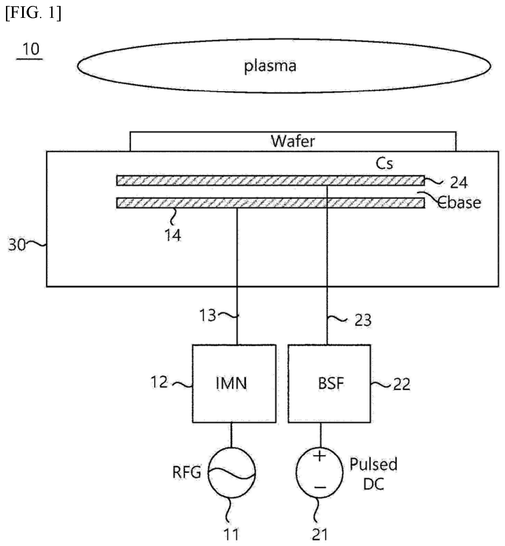

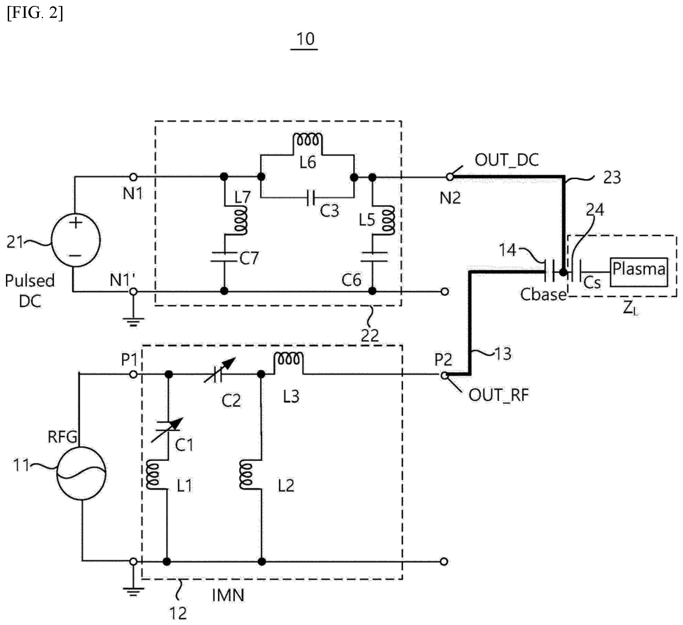

FIGS. 1 and 2 are diagrams illustrating conventional power delivery structures.

Referring to FIGS. 1 and 2, U.S. Patent No. 11,462,389 B2 suggested a technique using DC pulse bias instead of RF bias power. In such a plasma etching apparatus (10), DC pulse bias from a pulsed DC generator (21) is applied to a first electrode (or electrostatic electrode, 24) disposed on a substrate holder (30), and RF source power from an RF generator (11) is applied to a second electrode (14) disposed below the first electrode (24). The first electrode (24) and the second electrode (14) form a base capacitor (Cbase) with a dielectric therebetween. The pulsed DC generator (21) applies DC pulse bias to the first electrode through a BSF (22) and a power line (23). The RF generator (11) applies RF power to the second electrode (14) through an IMN (12) and a power line (13).

However, as the voltage of the DC pulse bias increases to several kV to tens of kV, high voltage is applied between the first electrode (24) and the second electrode (14), and the substrate holder (30) is damaged due to dielectric breakdown or abnormal discharge of the base capacitor (Cbase). Therefore, a new power delivery method capable of suppressing damage to the substrate holder (30) is required.

### [Disclosure of the Invention]

### [Technical Problem]

One technical problem to be solved by the present invention is to provide a power delivery apparatus that suppresses dielectric breakdown or abnormal discharge between a first electrode to which DC voltage is applied and a second electrode to which RF power is applied, mounted on a substrate holder.

Another technical problem to be solved by the present invention is to provide a substrate processing apparatus that integrates the electrode to which DC pulse voltage and RF power are applied into one, mounted on the substrate holder and places a DC blocking capacitor within an IMN.

Another technical problem to be solved by the present invention is to provide a power delivery apparatus including a BSF having an impedance converter that suppresses RF power of the RF generator from being transferred through the IMN to the pulsed DC generator.

Another technical problem to be solved by the present invention is to provide an IMN that delivers RF power from the RF generator to a load and a BSF that delivers DC pulse voltage from the pulsed DC generator to the load while preventing the RF power from flowing into the pulsed DC generator.

Another technical problem to be solved by the present invention is to provide a BSF that delivers DC pulse voltage from the pulsed DC generator to a load while suppressing overshoot and preventing RF power from the RF generator from flowing into the pulsed DC generator.

### [Solution to Problem]

A power delivery apparatus according to an embodiment of the present invention includes: an IMN for delivering RF power from an RF generator to a load; a BSF for delivering DC pulse voltage from a pulsed DC generator to the load and suppressing the RF power from being transferred to the pulsed DC generator; a DC blocking capacitor connected to an output terminal of the IMN and suppressing the DC pulse voltage through an output terminal of the BSF from being transferred to the IMN; and an impedance converter connected to an output terminal of the BSF and changing impedance of the RF power incident on the BSF. An output terminal of the impedance converter and an output terminal of the DC blocking capacitor are connected to each other and then connected to the load through a transmission line.

In an embodiment of the present invention, the DC blocking capacitor may be disposed inside the IMN, and the DC blocking capacitor may be a high-voltage vacuum capacitor or a high-voltage ceramic capacitor.

In an embodiment of the present invention, the DC blocking capacitor may be replaceable.

In an embodiment of the present invention, the DC blocking capacitor may comprise a plurality of capacitors connected in series with each other to increase withstand voltage.

In an embodiment of the present invention, the impedance converter may be disposed inside the BSF, the impedance converter may be an inductor, and reactance of the inductor may be 25 ohms to 500 ohms.

In an embodiment of the present invention, the load may include an electrode, a dielectric disposed on the electrode, a substrate disposed on the dielectric, and plasma formed on the substrate.

In an embodiment of the present invention, an absolute value of reactance of the impedance converter may be equal to or greater than an absolute value of reactance of the load.

In an embodiment of the present invention, the BSF may be a pi-type BSF having three or more stages.

In an embodiment of the present invention, the BSF may include a series resonator including an inductor and a capacitor connected in parallel with each other, and reactance of the inductor of the series resonator may be 200 ohms or less.

In an embodiment of the present invention, the BSF may include a shunt resonator including an inductor and a capacitor connected in series with each other. The shunt resonator may be connected to ground.

In an embodiment of the present invention, the RF generator may be a frequency-variable RF generator, the BSF may be a pi-type BSF having three or more stages, and the BSF may include a series resonator including an inductor and a variable capacitor connected in parallel. The variable capacitor of the series resonator may be varied according to a driving frequency of the RF generator, and a capacitance of the variable capacitor may be varied so that a resonance frequency of the series resonator matches the driving frequency of the RF generator.

In an embodiment of the present invention, an RF sensor disposed between the BSF and the pulsed DC generator; and a controller receiving an output signal of the RF sensor and calculating RF transmission power may be further included. The controller may provide an interrupt signal to the RF generator when the RF transmission power is equal to or greater than a threshold value.

In an embodiment of the present invention, the BSF may be a pi-type BSF having three or more stages, and the BSF may include a first shunt resonator including an inductor and a fixed capacitor connected in series.

A plasma substrate processing apparatus according to an embodiment of the present invention includes: a substrate holder including an electrode supporting a substrate and a dielectric disposed on the electrode; a chamber disposed to surround the substrate holder; an RF generator providing RF power to the electrode to generate plasma on the substrate; a pulsed DC generator providing DC pulse voltage to the electrode; and a power delivery unit delivering the RF power and the DC pulse voltage to the electrode. The power delivery unit includes: an IMN delivering the RF power from the RF generator to the electrode; a BSF delivering the DC pulse voltage from the pulsed DC generator to the electrode and suppressing the RF power from being transferred to the pulsed DC generator; a DC blocking capacitor connected to an output terminal of the IMN and suppressing a DC pulse through an output terminal of the BSF from being transferred to the IMN; and an impedance converter connected to an output terminal of the BSF and changing impedance of the BSF. An output terminal of the impedance converter and an output terminal of the DC blocking capacitor are connected to each other and then connected to the electrode through a transmission line.

In an embodiment of the present invention, the DC blocking capacitor may be disposed inside the IMN, and the DC blocking capacitor may be a high-voltage vacuum capacitor or a high-voltage ceramic capacitor.

In an embodiment of the present invention, the DC blocking capacitor may be replaceable.

In an embodiment of the present invention, the DC blocking capacitor may comprise a plurality of capacitors connected in series with each other to increase withstand voltage.

In an embodiment of the present invention, the impedance converter may be disposed inside the BSF, the impedance converter may be an inductor, and reactance of the inductor may be 25 ohms to 500 ohms.

In an embodiment of the present invention, an absolute value of reactance of the impedance converter may be equal to or greater than an absolute value of reactance of the load.

A power delivery apparatus according to an embodiment of the present invention includes: an IMN for delivering RF power from an RF generator to a load; a BSF for delivering DC pulse voltage from a pulsed DC generator to the load and suppressing the RF power from being transferred to the pulsed DC generator; a DC blocking capacitor connected to an output terminal of the IMN and suppressing the DC pulse voltage through an output terminal of the BSF from being transferred to the IMN; wherein an output terminal of the BSF and an output terminal of the DC blocking capacitor are connected to each other and then connected to the load through a transmission line.

### [Advantageous Effects]

A power delivery apparatus according to an embodiment of the present invention suppresses dielectric breakdown or abnormal discharge between a first electrode to which DC voltage is applied and a second electrode to which RF power is applied, mounted on a substrate holder.

A power delivery apparatus according to an embodiment of the present invention can integrate the electrode to which DC pulse voltage and RF power are applied into one, mounted on the substrate holder, place a DC blocking capacitor within an IMN, and provide a compact power delivery structure.

A power delivery apparatus according to an embodiment of the present invention can provide a BSF including an impedance converter that suppresses RF power of the RF generator from being transferred to the pulsed DC generator side through the IMN.

A power delivery apparatus according to an embodiment of the present invention can provide an IMN that delivers RF power from the RF generator to a load and a BSF that delivers DC pulse voltage from the pulsed DC generator to the load while preventing the RF power from flowing into the pulsed DC generator.

A power delivery apparatus according to an embodiment of the present invention can provide a BSF that delivers DC pulse voltage from the pulsed DC generator to a load while suppressing overshoot and preventing RF power from the RF generator from flowing into the pulsed DC generator.

### [Brief Description of the Drawings]

FIGS. 1 and 2 are diagrams illustrating conventional power delivery structures.
FIG. 3 is a conceptual diagram illustrating a plasma substrate processing apparatus and a power delivery apparatus according to an embodiment of the present invention.
FIG. 4 is a circuit diagram illustrating the plasma substrate processing apparatus and the power delivery apparatus of FIG. 3.
FIG. 5 is a diagram illustrating connection relationships of DC blocking capacitors according to another embodiment of the present invention.
FIG. 6 is a diagram illustrating impedance viewed from a load direction toward a power delivery unit direction according to an embodiment of the present invention.
FIG. 7 illustrates impedance changes when an impedance converter is added to the power delivery unit.
FIG. 8 is a simulation result showing an operating range of the IMN according to reactance of the impedance converter according to an embodiment of the present invention.
FIGS. 9a and 9b illustrate transmission characteristics of the BSF according to inductance of the impedance converter according to an embodiment of the present invention.
FIGS. 10a and 10b illustrate an operating range of the IMN when the BSF is removed from the power delivery apparatus according to an embodiment of the present invention.
FIGS. 11a to 11c illustrate an operating range of the IMN when the BSF is included in the power delivery apparatus according to an embodiment of the present invention.
FIGS. 12a to 12c are diagrams illustrating characteristics of the BSF according to an embodiment of the present invention.
FIGS. 13a to 13e are diagrams illustrating characteristics of the BSF according to an embodiment of the present invention.
FIG. 14 is a simulation result showing overshoot according to a series inductor in the BSF of the power delivery apparatus according to an embodiment of the present invention.

### [Best Mode for Carrying Out the Invention]

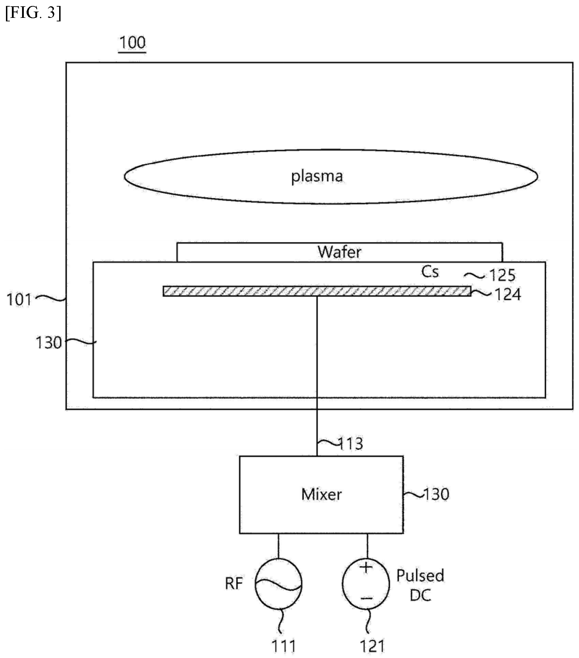

Hereinafter, preferred embodiments of the present invention will be described specifically with reference to the accompanying drawings. However, the present invention is not limited to the embodiments described herein and may be embodied in other forms. Rather, the embodiments introduced herein are provided so that the disclosed content will be thorough and complete and the spirit of the present invention will be fully conveyed to those skilled in the art. In the drawings, components are exaggerated for clarity. Throughout the specification, portions indicated by the same reference numerals represent the same components. FIG. 3 is a conceptual diagram illustrating a plasma substrate processing apparatus and a power delivery apparatus according to an embodiment of the present invention.

FIG. 3 is a conceptual diagram illustrating a plasma substrate processing apparatus and a power delivery apparatus according to an embodiment of the present invention.

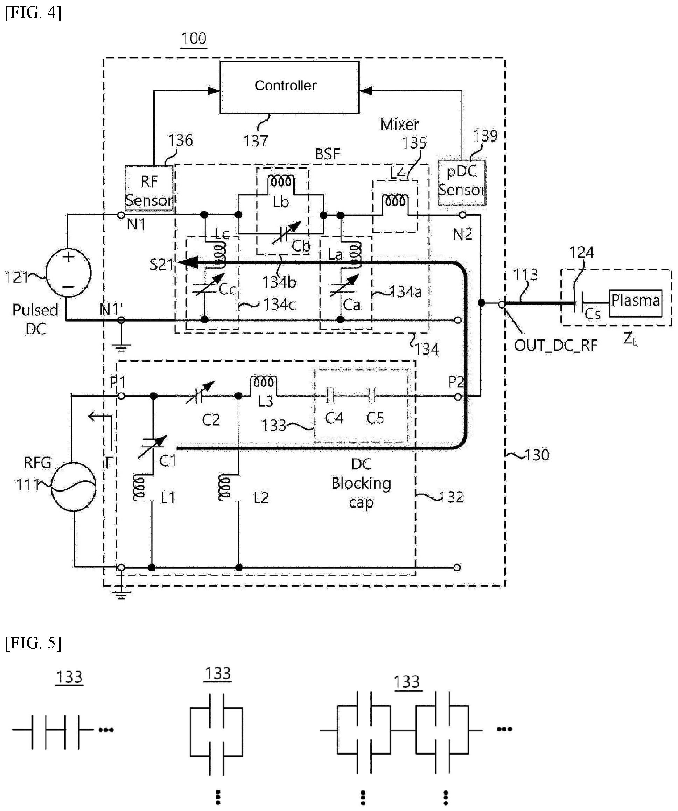

FIG. 4 is a circuit diagram illustrating the plasma substrate processing apparatus and the power delivery apparatus of FIG. 3.

Referring to FIGS. 3 and 4, a plasma substrate processing apparatus (100) according to an embodiment of the present invention includes a substrate holder (130), a chamber (101), an RF generator (111), and a power delivery unit (130).

The plasma substrate processing apparatus (100) may be a plasma etching apparatus. The chamber (101) may be a cylindrical chamber or a rectangular chamber made of metal. The chamber (101) may further include a vacuum system and a gas injection system. The chamber (101) may maintain a low pressure (hundreds of millitorr to several millitorr) for plasma formation. The plasma substrate processing apparatus (100) may anisotropically etch a silicon oxide film or a silicon nitride film on a substrate. The chamber (101) may be disposed to surround the substrate holder (130).

The substrate may be a semiconductor substrate. The semiconductor substrate may be a silicon substrate on which semiconductor devices are formed.

The substrate holder (130) supports the substrate and may include an electrode (124) and a dielectric (125) disposed on the electrode (124). The substrate holder (130) may be disposed inside the chamber (101). The electrode (124) may receive RF power and DC pulse voltage. The electrode (124) may also operate as an electrostatic electrode of an electrostatic chuck.

The RF generator (111) may provide RF power to the electrode (124) to generate plasma on the substrate. The RF generator (111) may generate a sinusoidal wave. A driving frequency of the RF generator (111) may be tens of MHz or higher. RF power from the RF generator (111) may be delivered to the electrode (124) to form plasma on the substrate.

The pulsed DC generator (121) may output DC pulse voltage. The DC pulse voltage may be a bipolar voltage waveform. The DC pulse voltage may have a constant period and have a positive voltage and a negative voltage. Also, in a section where the negative voltage is applied, the voltage waveform may have a slope voltage where the negative voltage decreases with time. The DC pulse voltage may form an electric field between the electrode (124) and the substrate to provide an electrostatic force for attracting the substrate. The DC pulse voltage may form a strong electric field in a plasma sheath existing between the substrate and the plasma, and ions of the plasma may be accelerated by the electric field of the plasma sheath and provide a bias voltage for incidence on the substrate. Energy of the ions may improve anisotropic etching characteristics of the substrate.

The power delivery unit (130) delivers the RF power and the DC pulse voltage to the electrode (124). The power delivery unit (130) combines the RF power and the DC pulse voltage to deliver power to the electrode (124). The DC pulse voltage is mainly applied to the DC blocking capacitor (133) and a substrate capacitor Cs between the electrode (124) and the substrate. The DC blocking capacitor (133) is not installed inside the substrate holder (130) but is disposed in the IMN (132). Therefore, when the DC pulse voltage of several kV to tens of kV is applied to the DC blocking capacitor (133), the DC blocking capacitor (133) may provide stable operation without abnormal operation such as dielectric breakdown by using a high-voltage vacuum capacitor. The RF power and the DC pulse voltage are combined and applied to the electrode (124) through one transmission line (113). Meanwhile, when a plurality of transmission lines or power lines are used, the plurality of transmission lines or power lines may cause abnormal operation in the chamber or the substrate holder. Therefore, by using one transmission line (113), abnormal operation is reduced, and operational stability is improved.

The power delivery unit (130) may include an IMN (132), a BSF (134), a DC blocking capacitor (133), and an impedance converter (135).

The IMN (132) delivers the RF power from the RF generator (111) to the electrode (124). The IMN (132) may be an L-type, inverted L-type, T-type, or Pi-type. The IMN (132) may include at least two variable reactive elements. The variable reactive elements may be vacuum variable capacitors.

Exemplarily, the IMN (132) includes a first variable capacitor (C1) and a second variable capacitor (C2) connected to an output terminal of the RF generator. One end of the first variable capacitor (C1) is connected to an output terminal of the RF generator (111), and the other end of the first variable capacitor (C2) may be connected in series with a first inductor (L1) and then connected to ground. One end of the second variable capacitor (C2) is connected to an output terminal of the RF generator (111), and the other end of the second variable capacitor (C2) is connected to one end of a second inductor (L2) and one end of a third inductor (L3). The other end of the second inductor (L2) is grounded. The other end of the third inductor (L3) is connected to an output terminal of the IMN (132).

The DC blocking capacitor (133) is connected to an output terminal of the IMN (132) and suppresses a DC pulse through an output terminal of the BSF (134) from being transferred to the IMN (132). The DC blocking capacitor (133) is disposed inside the IMN (132), and the DC blocking capacitor (133) may be a high-voltage vacuum capacitor or a high-voltage ceramic capacitor. The DC blocking capacitor (133) is a separate component separated from the substrate holder (130), and the DC blocking capacitor (133) is replaceable. In particular, when the DC blocking capacitor (133) is damaged by DC pulse voltage, the DC blocking capacitor (133) can be easily replaced.

The DC blocking capacitor (133) may include a plurality of capacitors (C4), (C5) connected in series with each other to increase withstand voltage.

The BSF (134) delivers the DC pulse voltage from the pulsed DC generator (121) to the electrode (124) and suppresses the RF power from being transferred to the pulsed DC generator (121). The BSF (134) may be a pi-type BSF having three or more stages. When the BSF (134) is a three-stage pi-type BSF, it may include a 1st stage resonator (134a), a 2nd stage resonator (134b), and a 3rd stage resonator (134c). The 1st stage resonator (134a) may include an inductor (La) and a capacitor (Ca) connected in series with each other. The 2nd stage resonator (134b) may include an inductor (Lb) and a capacitor (Cb) connected in parallel with each other. The 3rd stage resonator (134c) may include an inductor (Lc) and a capacitor (Cc) connected in series with each other. Resonance frequencies of the 1st to 3rd stage resonators (134a), (134b), (134c) may match a driving frequency of the RF power. The 3rd stage resonator (134c) may be connected to an output terminal of the pulsed DC generator (121). One end of the 2nd stage resonator (134b) may be connected to an output terminal of the pulsed DC generator (121). The 1st stage resonator (134a) may be connected to the other end of the 2nd stage resonator (134b). The 1st stage resonator (134a) and the 3rd stage resonator (134c) may be shunt resonators. The 2nd stage resonator (134b) may be a series resonator. The BSF (134) may suppress RF power from traveling toward the pulsed DC generator (121) side, maintaining RF power of several watts or less at an output terminal of the pulsed DC generator (121).

The BSF (134) may include a series resonator (134b) including an inductor (Lb) and a capacitor (Cb) connected in parallel with each other. Reactance of the inductor (Lb) of the series resonator (134b) may be 200 ohms or less.

The BSF (134) may include a shunt resonator (134a) including an inductor (La) and a capacitor (Ca) connected in series with each other. The shunt resonator (134a) may be connected to ground, and an absolute value of reactance of capacitors (Ca), (Cc) of the shunt resonators (134a), (134c) may be 200 ohms or less.

The BSF (134) may be designed to minimize distortion of DC pulse waveforms. Distortion of DC pulse waveforms (e.g., overshoot) may damage the substrate holder (130) and the power delivery apparatus (130). When the order of the BSF (134) increases, overshoot increases and RF transmission power (e.g., scattering coefficient S21) decreases. Also, series connection (or order increase) of the BSF (134) increases overshoot. Therefore, an appropriate order (or stage) selection is required. According to the present invention, the order of the BSF (134) may preferably be 3 to 5 stages. In the form of the BSF (134), pi-type may be advantageous in terms of overshoot compared to T-type.

The impedance converter (135) is connected to an output terminal of the BSF (134) and changes impedance of the BSF (134). The impedance converter (135) may be connected to a junction between the 1st stage resonator (134a) and the 2nd stage resonator (134b). The impedance converter (135) may change impedance of the 1st stage resonator (134a) to have high impedance. RF power incident on the impedance converter (135) may be reflected by the high impedance. The impedance converter (135) may be disposed inside the BSF (134). The impedance converter (135) is an inductor (L4), and reactance of the inductor (L4) may be 25 ohms to 500 ohms.

An output terminal of the impedance converter (135) and an output terminal of the DC blocking capacitor (133) are connected to each other and then connected to the electrode (124) through a transmission line (113). The transmission line (113) may be a high-voltage coaxial cable. A characteristic impedance of the transmission line (113) may be 50 ohms.

The load may include an electrode (124), a dielectric (125) disposed on the electrode (124), a substrate disposed on the dielectric (125), and plasma formed on the substrate. The load may include a negative reactive component. RF power incident on a junction between an output terminal of the impedance converter (135) and an output terminal of the DC blocking capacitor (133) mainly travels in a direction having lower impedance. Therefore, an absolute value of reactance of the impedance converter (135) may be equal to or greater than an absolute value of reactance of the load. Accordingly, RF power may mainly travel in the load direction.

An RF sensor (136) may be disposed between the BSF (134) and the pulsed DC generator (121). The RF sensor (136) may include a current sensor and a voltage sensor.

A controller (137) may receive an output signal of the RF sensor (136) and calculate RF transmission power. The controller (137) may provide an interrupt signal to the RF generator (111) or a warning signal to a user when the RF transmission power is equal to or greater than a threshold value.

A voltage sensor (139) may be disposed at an output terminal of the BSF (134). The voltage sensor (139) may measure a waveform of DC pulse voltage and provide it to the controller (137). The controller (137) may analyze the waveform of the DC pulse voltage and display it to the user. Analysis of the waveform may be an amount of overshoot.

The RF generator (111) may be a frequency-variable RF generator, the BSF (134) may be a pi-type BSF having three or more stages, and the BSF (134) may include a series resonator including an inductor (Lb) and a variable capacitor (Cb) connected in parallel. The variable capacitor (Cb) of the series resonator may be varied according to a driving frequency of the RF generator (111). A capacitance of the variable capacitor (Cb) may be varied so that a resonance frequency of the series resonator matches the driving frequency of the RF generator. The 1st stage resonator (134a) may include an inductor (La) and a capacitor (Ca) connected in series with each other. The 2nd stage resonator (134b) may include an inductor (Lb) and a capacitor (Cb) connected in parallel with each other. The 3rd stage resonator (134c) may include an inductor (Lc) and a capacitor (Cc) connected in series with each other. Capacitances of the capacitor (Ca) of the 1st stage resonator (134a) and the capacitor (Cc) of the 3rd stage resonator (134c) may be varied to match the driving frequency of the RF generator.

According to a modified embodiment of the present invention, even when the RF generator (111) is a frequency-variable RF generator, the capacitor (Ca) of the 1st stage resonator (134a) may use a fixed value.

FIG. 5 is a diagram illustrating connection relationships of DC blocking capacitors according to another embodiment of the present invention.

Referring to FIG. 5, the DC blocking capacitor (133) may include a plurality of capacitors connected in series with each other. Accordingly, the applied voltage may be equally distributed to the capacitors, and a dielectric breakdown voltage of each capacitor may be reduced.

The DC blocking capacitor (133) may include a plurality of capacitors connected in parallel with each other. Accordingly, RF power may increase current driving capability due to the low impedance of the DC blocking capacitor.

The DC blocking capacitor (133) may include a plurality of capacitors connected in series and in parallel with each other. Accordingly, current driving capability and dielectric breakdown voltage may be reduced. A maximum capacitance of the DC blocking capacitor (133) may be 50 pF.

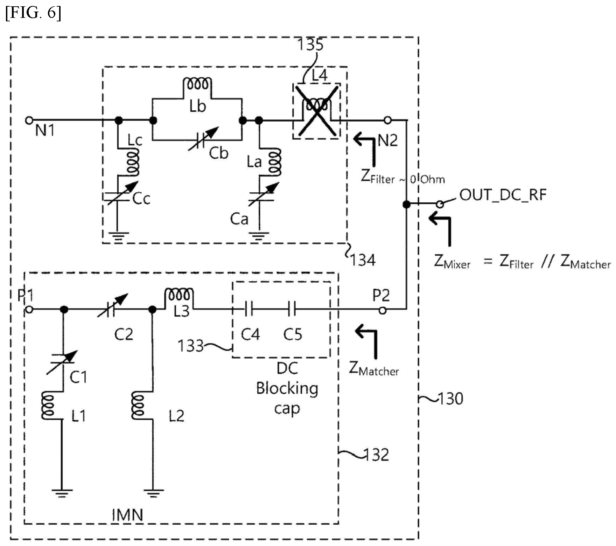

FIG. 6 is a diagram illustrating impedance viewed from a load direction toward a power delivery unit direction according to an embodiment of the present invention.

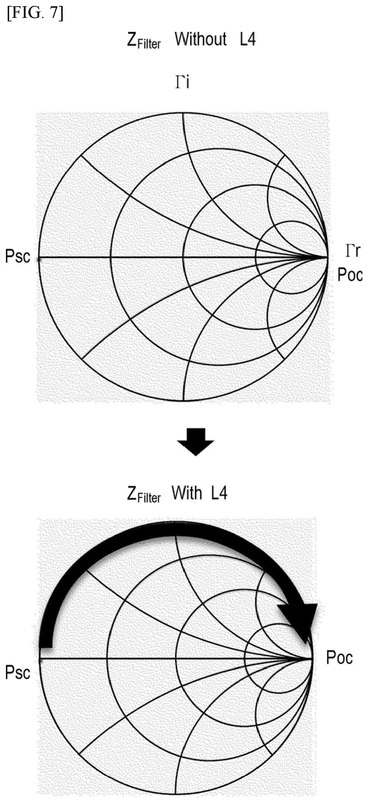

FIG. 7 illustrates impedance changes when an impedance converter is added to the power delivery unit.

Referring to FIGS. 6 and 7, RF power reflected from the load sees impedance of the IMN (132) and impedance of the BSF (134). If there is no impedance converter (135), the impedance of the BSF (134) approaches almost zero. Therefore, reflected waves reflected from the load are transmitted through the BSF (134). Therefore, to increase the impedance of the BSF (134), an impedance converter (135) is required. Reactance of the impedance converter (135) may be 200 ohms or more. For example, at 60 MHz, inductance of the impedance converter (135) may be 500 nH or more. When impedance of the impedance converter (135) is very large, on a Smith chart, the impedance of the BSF (134) changes from a short circuit to an open circuit.

Meanwhile, when inductance of the impedance converter (135) increases, distortion of DC pulse waveforms (e.g., overshoot) may increase. Therefore, an absolute value of reactance of the impedance converter (135) may be set to be greater than an absolute value of reactance of the load.

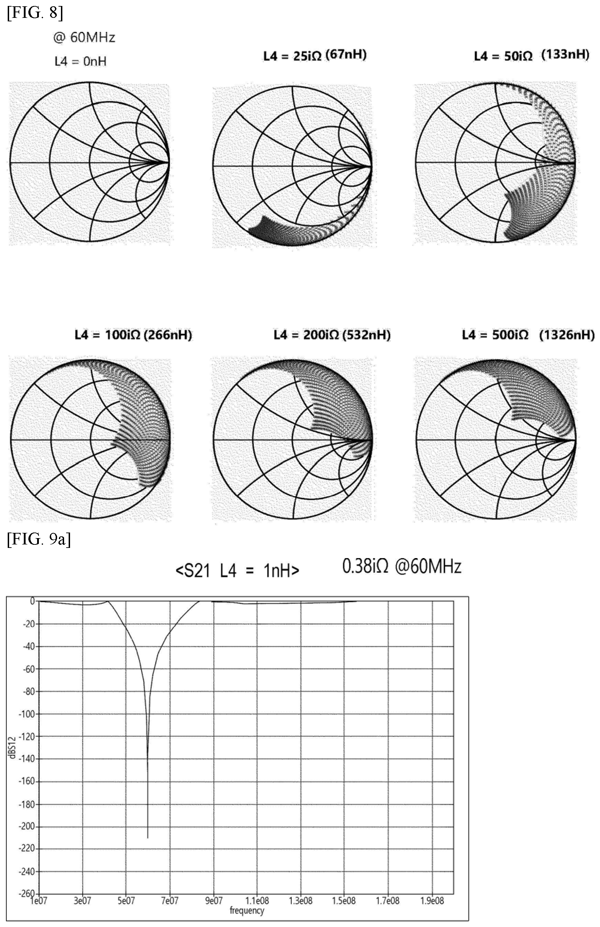

FIG. 8 is a simulation result showing an operating range of the IMN according to reactance of the impedance converter according to an embodiment of the present invention.

Referring to FIG. 8, when the impedance converter (135) is an inductor (L4) and reactance of the inductor (L4) is 25 ohms, 50 ohms, 100 ohms, 200 ohms, and 500 ohms, an operating range of the IMN is displayed on a Smith chart respectively. Therefore, for the IMN (132) to operate efficiently, reactance of the impedance converter (135) may be 50 ohms to 500 ohms.

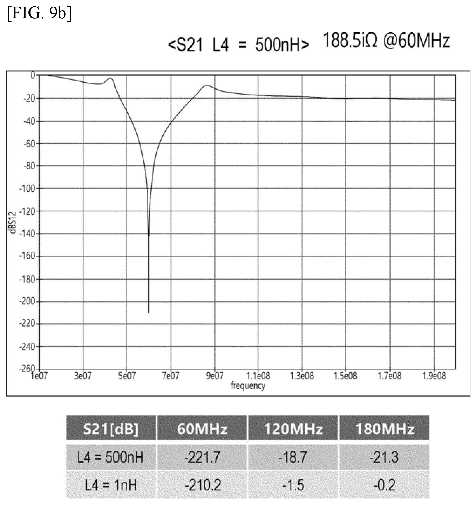

FIGS. 9a and 9b illustrate transmission characteristics of the BSF according to inductance of the impedance converter according to an embodiment of the present invention.

Referring to FIGS. 9a and 9b, S12 is a transmission coefficient or scattering coefficient between the RF generator (111) and the pulsed DC generator (121). When a resonance frequency of the BSF (134) matches a driving frequency of 60 MHz, RF power from the RF generator (111) decreases to -200 dB or less at 60 MHz.

Meanwhile, when inductance of the impedance converter (135) is 1 nH, there is no change in transmittance at harmonics (120 MHz, 180 MHz). However, when inductance of the impedance converter (135) is 500 nH, transmittance changes at harmonics (120 MHz, 180 MHz). The impedance converter (135) operates as a kind of low-pass filter, having an effect of suppressing high-frequency components. However, when inductance of the impedance converter (135) increases, distortion of DC pulse waveforms (e.g., overshoot) may increase. Therefore, an absolute value of reactance of the impedance converter (135) may be set to be greater than an absolute value of reactance of the load.

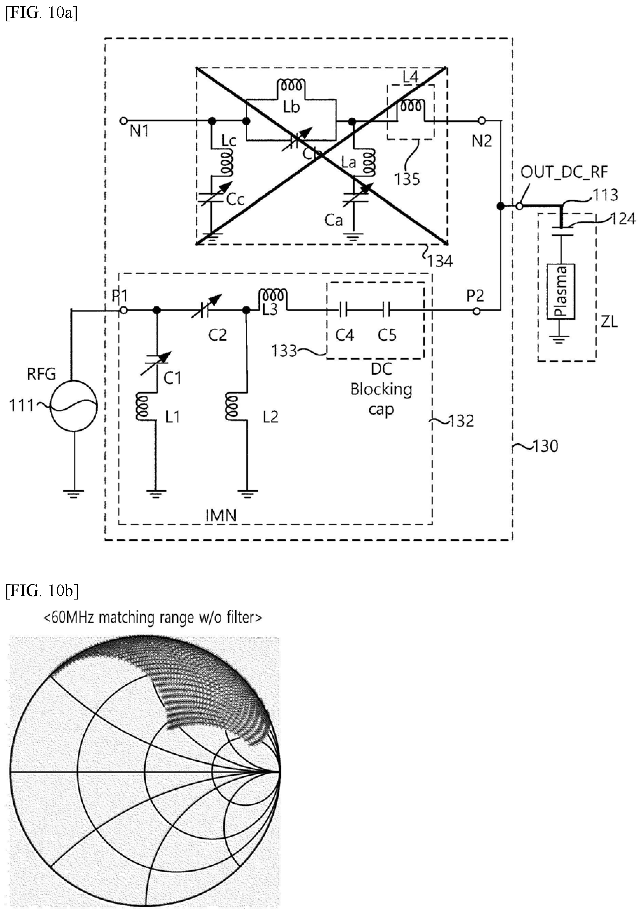

FIGS. 10a and 10b illustrate an operating range of the IMN when the BSF is removed from the power delivery apparatus according to an embodiment of the present invention.

Referring to FIGS. 10a and 10b, when the BSF (134) is removed from the power delivery apparatus (130), the power delivery apparatus (130) operates as a general IMN. If load impedance exists within the displayed region, power generated from a power source can be delivered to the load without loss.

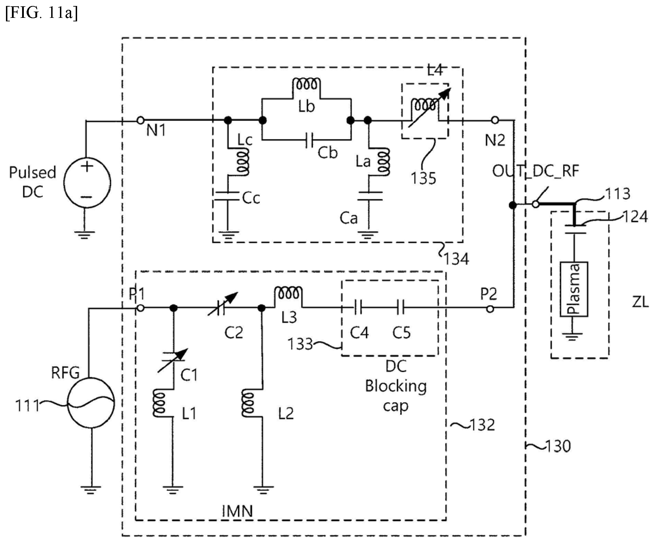

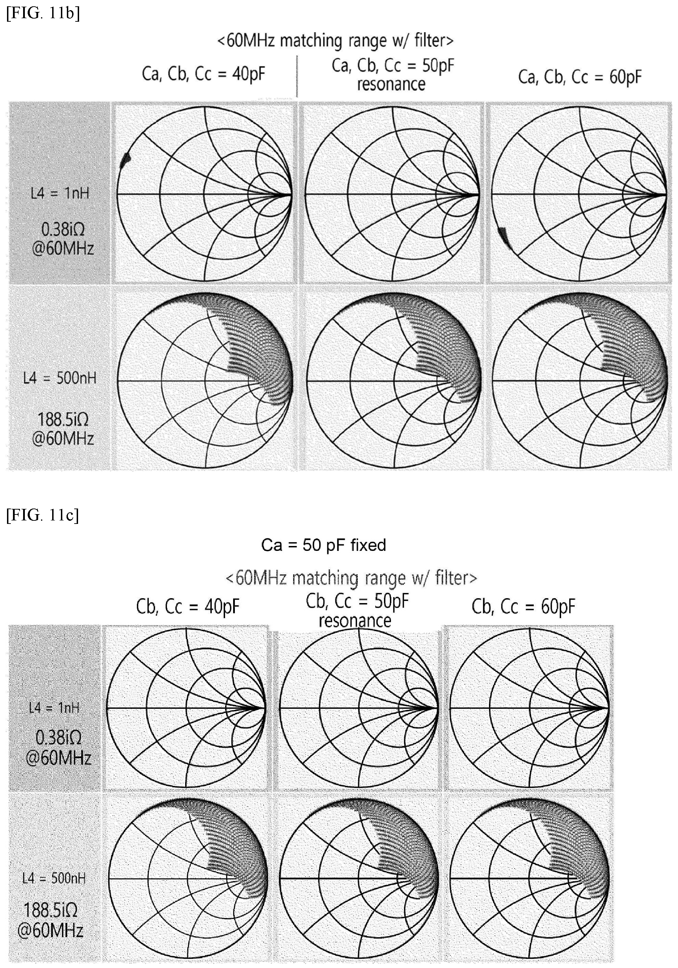

FIGS. 11a to 11c illustrate an operating range of the IMN when the BSF is included in the power delivery apparatus according to an embodiment of the present invention.

Referring to FIGS. 11a to 11b, in simulations, Ca, Cb, Cc = 40, 50, 60 pF. When the power delivery apparatus (130) includes the BSF (134), when inductance of the impedance converter (135) is 1 nH, an operating range of the IMN (132) is very narrow. However, when inductance of the impedance converter (135) is 500 nH, an operating range of the IMN (132) is very wide. Therefore, stable impedance matching operation can be performed according to the load.

Referring to FIGS. 11a to 11c, in simulations, Cb, Cc = 40, 50, 60 pF. Ca = 50 pF. When the power delivery apparatus (130) includes the BSF (134), when inductance of the impedance converter (135) is 1 nH, an operating range of the IMN (132) is very narrow. However, when inductance of the impedance converter (135) is 500 nH, an operating range of the IMN (132) is very wide. Therefore, stable impedance matching operation can be performed according to the load.

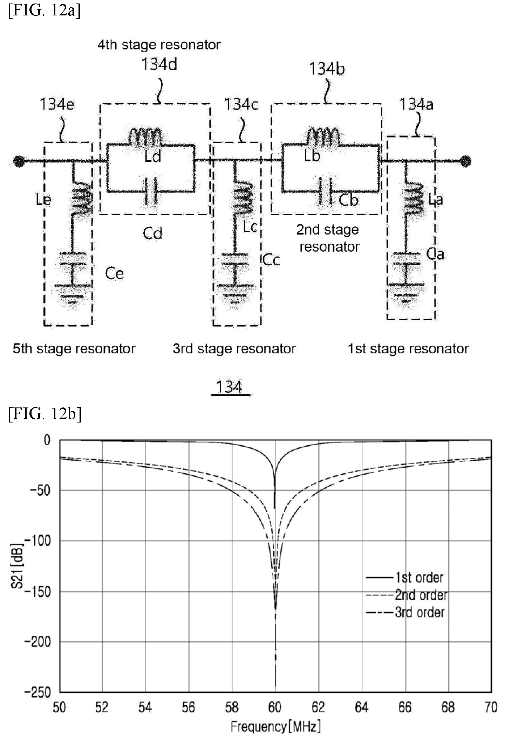

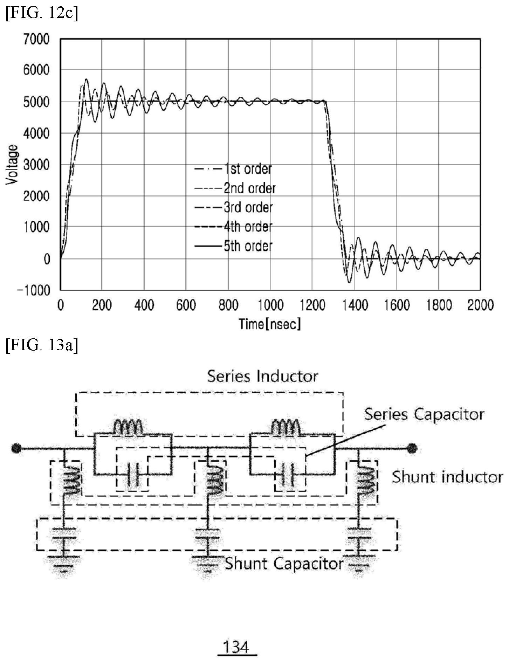

FIGS. 12a to 12c are diagrams illustrating characteristics of the BSF according to an embodiment of the present invention.

Referring to FIGS. 12a to 12c, the BSF (134) includes 1st to 5th stage resonators 134a to 134e and may be pi-type. Transmittance (or scattering matrix S21) of a BSF having only the 1st stage resonator (134a) shows relatively high transmittance at a resonance frequency of 60 MHz. Meanwhile, as the number of stages (or order) of the BSF (134) increases to 2nd order and 3rd order, relatively low transmittance is shown at a resonance frequency of 60 MHz. Therefore, the BSF (134) may be a pi-type filter having three or more stages.

Meanwhile, waveforms of DC pulse voltage show that a 1st stage BSF has the best overshoot characteristics. That is, as the order (or number of stages) of the BSF (134) increases, overshoot increases. Therefore, considering overshoot, the BSF (134) may be a pi-type filter having five or fewer stages.

FIGS. 13a to 13e are diagrams illustrating characteristics of the BSF according to an embodiment of the present invention.

Referring to FIGS. 13a to 13e, the BSF (134) may be a 5-stage BSF. The BSF (134) includes a series inductor, a series capacitor, a shunt inductor, and a shunt capacitor.

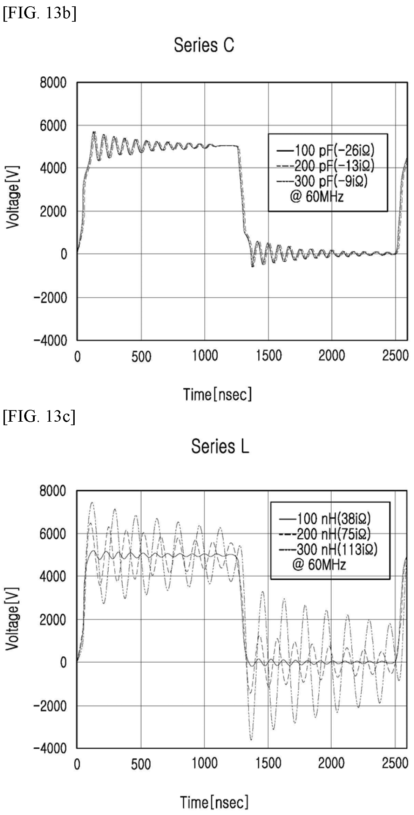

Referring to FIG. 13b, when the series capacitor is varied to 100 pF, 200 pF, and 300 pF, waveforms of DC pulse voltage hardly change.

Referring to FIG. 13c, when the series inductor is varied to 100 nH, 200 nH, and 300 nH, in waveforms of DC pulse voltage, overshoot increases as inductance increases. Therefore, inductance of the series inductor may be 200 nH or less.

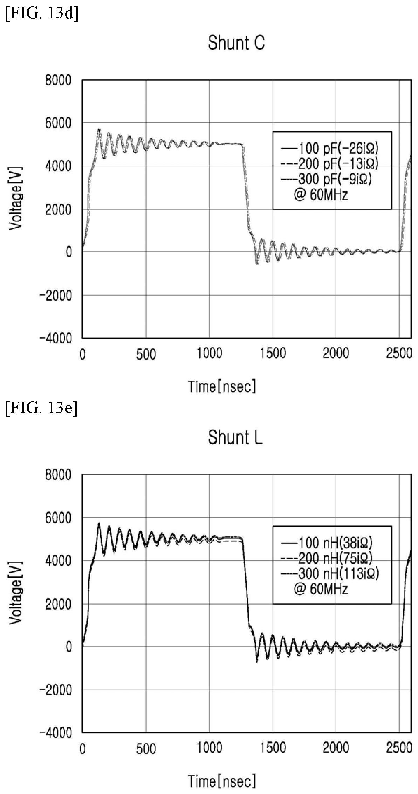

Referring to FIG. 13d, when the shunt capacitor is varied to 100 pF, 200 pF, and 300 pF, in waveforms of DC pulse voltage, overshoot slightly decreases as a capacitance increases. Therefore, a capacitance of the shunt capacitor may be 100 pF or more.

Referring to FIG. 13e, when the shunt inductor is varied to 100 nH, 200 nH, and 300 nH, in waveforms of DC pulse voltage, overshoot does not change as inductance increases.

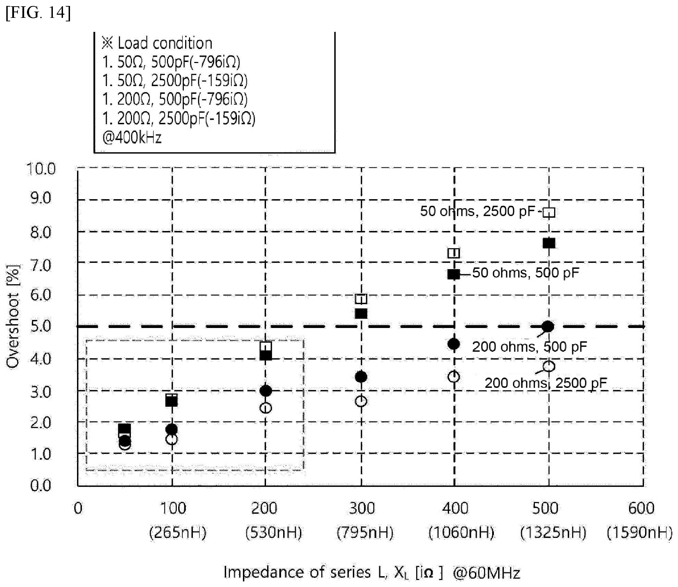

FIG. 14 is a simulation result showing overshoot according to a series inductor in the BSF of the power delivery apparatus according to an embodiment of the present invention.

Referring to FIG. 14, when reactance of the series inductor is 200 ohms or less, overshoot is maintained within 5%. In simulations, a 3-stage pi-type BSF was used. A frequency of DC pulse voltage is 400 kHz, duty is 50%, rise time and fall time are 250 nsec, and maximum voltage is 10 kV. A real resistance of the load is 50 to 200 ohms, and a capacitance of the load is 500 pF to 2500 pF.

To maintain overshoot less than 5%, reactance of the series inductor may be maintained at 200 ohms or less.

Although the present invention has been shown and described with respect to specific preferred embodiments, the present invention is not limited to these embodiments, and it should be understood that various modifications and variations can be made by those skilled in the art within the technical scope claimed in the appended claims.

### [Reference Signs List]

111: RF generator
121: pulsed DC generator
130: Power delivery apparatus
132: IMN
134: BSF
133: DC blocking capacitor
135: Impedance converter

## Claims

1. A power delivery apparatus comprising:
an impedance matching network (IMN) for delivering RF power from an RF generator to a load;
a band-stop filter (BSF) for delivering DC pulse voltage from a pulsed DC generator to the load and suppressing the RF power from being transferred to the pulsed DC generator;
a DC blocking capacitor connected to an output terminal of the IMN and suppressing the DC pulse voltage through an output terminal of the BSF from being transferred to the IMN; and
an impedance converter connected to an output terminal of the BSF and changing impedance of the RF power incident on the BSF,
wherein an output terminal of the impedance converter and an output terminal of the DC blocking capacitor are connected to each other and then connected to the load through a transmission line.

2. The power delivery apparatus of claim 1,
wherein the DC blocking capacitor is disposed inside the IMN, and
the DC blocking capacitor is a high-voltage vacuum capacitor or a high-voltage ceramic capacitor.

3. The power delivery apparatus of claim 1,
wherein the DC blocking capacitor is replaceable.

4. The power delivery apparatus of claim 1,
wherein the DC blocking capacitor comprises a plurality of capacitors connected in series with each other to increase withstand voltage.

5. The power delivery apparatus of claim 1,
wherein the impedance converter is disposed inside the BSF,
the impedance converter is an inductor, and
reactance of the inductor is 25 ohms to 500 ohms.

6. The power delivery apparatus of claim 1,
wherein the load comprises an electrode, a dielectric disposed on the electrode, a substrate disposed on the dielectric, and plasma formed on the substrate.

7. The power delivery apparatus of claim 1,
wherein an absolute value of reactance of the impedance converter is equal to or greater than an absolute value of reactance of the load.

8. The power delivery apparatus of claim 1,
wherein the BSF is a pi-type band-stop filter having three or more stages.

9. The power delivery apparatus of claim 8,
wherein the BSF comprises a series resonator including an inductor and a capacitor connected in parallel with each other, and
reactance of the inductor of the series resonator is 200 ohms or less.

10. The power delivery apparatus of claim 8,
wherein the BSF comprises a shunt resonator including an inductor and a capacitor connected in series with each other, and
the shunt resonator is connected to ground.

11. The power delivery apparatus of claim 1,
wherein the RF generator is a frequency-variable RF generator,
the BSF is a pi-type band-stop filter having three or more stages,
the BSF comprises a series resonator including an inductor and a variable capacitor connected in parallel,
the variable capacitor of the series resonator is varied according to a driving frequency of the RF generator, and
a capacitance of the variable capacitor is varied so that a resonance frequency of the series resonator matches the driving frequency of the RF generator.

12. The power delivery apparatus of claim 1, further comprising:
an RF sensor disposed between the BSF and the pulsed DC generator; and
a controller receiving an output signal of the RF sensor and calculating RF transmission power,
wherein the controller provides an interrupt signal to the RF generator when the RF transmission power is equal to or greater than a threshold value.

13. The power delivery apparatus of claim 1,
wherein the BSF is a pi-type band-stop filter having three or more stages, and
the BSF comprises a first shunt resonator including an inductor and a fixed capacitor connected in series.

14. A plasma substrate processing apparatus comprising:
a substrate holder including an electrode supporting a substrate and a dielectric disposed on the electrode;
a chamber disposed to surround the substrate holder;
an RF generator providing RF power to the electrode to generate plasma on the substrate;
a pulsed DC generator providing DC pulse voltage to the electrode; and
a power delivery unit delivering the RF power and the DC pulse voltage to the electrode,
wherein the power delivery unit comprises:
an impedance matching network (IMN) delivering the RF power from the RF generator to the electrode;
a band-stop filter (BSF) delivering the DC pulse voltage from the pulsed DC generator to the electrode and suppressing the RF power from being transferred to the pulsed DC generator;
a DC blocking capacitor connected to an output terminal of the IMN and suppressing a DC pulse through an output terminal of the BSF from being transferred to the IMN; and
an impedance converter connected to an output terminal of the BSF and changing impedance of the BSF,
wherein an output terminal of the impedance converter and an output terminal of the DC blocking capacitor are connected to each other and then connected to the electrode through a transmission line.

15. The plasma substrate processing apparatus of claim 14,
wherein the DC blocking capacitor is disposed inside the IMN, and
the DC blocking capacitor is a high-voltage vacuum capacitor or a high-voltage ceramic capacitor.

16. The plasma substrate processing apparatus of claim 14,
wherein the DC blocking capacitor is replaceable.

17. The power delivery apparatus of claim 14,
wherein the DC blocking capacitor comprises a plurality of capacitors connected in series with each other to increase withstand voltage.

18. The plasma substrate processing apparatus of claim 14,
wherein the impedance converter is disposed inside the BSF,
the impedance converter is an inductor, and
reactance of the inductor is 25 ohms to 500 ohms.

19. The plasma substrate processing apparatus of claim 14,
wherein an absolute value of reactance of the impedance converter is equal to or greater than an absolute value of reactance of the load.

20. A power delivery apparatus comprising:
an impedance matching network (IMN) for delivering RF power from an RF generator to a load;
a band-stop filter (BSF) for delivering DC pulse voltage from a pulsed DC generator to the load and suppressing the RF power from being transferred to the pulsed DC generator; and
a DC blocking capacitor connected to an output terminal of the IMN and suppressing DC pulse voltage through an output terminal of the BSF from being transferred to the IMN,
wherein an output terminal of the BSF and an output terminal of the DC blocking capacitor are connected to each other and then connected to the load through a transmission line.
